# EUROPÄISCHE PATENTSCHRIFT

(11) **EP 2 883 431 B1**
(45) Veröffentlichungstag und Bekanntmachung des Hinweises auf die Patenterteilung: **22.02.2017**
(21) Anmeldenummer: 13727922.0
(22) Anmeldetag: 11.06.2013
(51) Int. Cl.: H05K 5/00, F16H 61/00, H05K 7/20

(54) **GETRIEBESTEUERMODUL EINES KRAFTFAHRZEUGGETRIEBES IN SANDWICHBAUWEISE MIT ABGEDICHTET ANGEORDNETEN BAUELEMENTEN**
GEAR CONTROL MODULE OF A MOTOR VEHICLE GEAR MECHANISM OF A SANDWICH CONSTRUCTION WITH STRUCTURAL ELEMENTS ARRANGED IN A SEALED MANNER
MODULE DE COMMANDE DE BOÎTE DE VITESSES D'UNE BOÎTE DE VITESSES DE VÉHICULE AUTOMOBILE À CONSTRUCTION EN SANDWICH, COMPORTANT DES ÉLÉMENTS DE CONSTRUCTION DISPOSÉS DE FAÇON ÉTANCHE

(30) Priorität: 07.08.2012 DE 102012213952
(43) Veröffentlichungstag der Anmeldung: 17.06.2015
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2013/062031
(87) Internationale Veröffentlichungsnummer: WO 2014/023460

(56) Entgegenhaltungen:
- EP-A1- 2 040 527
- WO-A1-2013/091941
- DE-A1-102007 042 593
- DE-B3-102006 047 187

## Beschreibung

### Gebiet der Erfindung

Die vorliegende Erfindung betrifft ein Getriebesteuermodul eines Kraftfahrzeuggetriebes, mit einer Trägerplatte, die auf einer ersten Seite an einem Getriebebauteil befestigbar ist, und auf einer zweiten Seite, die der ersten Seite gegenüberliegt, ein Aufnahmevolumen mit einer Bodenfläche und einer umlaufenden Wandung bildet, und einer primären Leiterplatte, die flächig und plattenförmig ausgebildet ist und mit Anschlüssen für eine externe Verbindung versehen ist, wobei die primäre Leiterplatte an der Trägerplatte befestigt ist. Die Erfindung betrifft ferner ein Getriebe für ein Kraftfahrzeug und ein Verfahren für den Zusammenbau eines Getriebesteuermoduls.

### Stand der Technik

Getriebesteuermodule werden in Kraftfahrzeugen beispielsweise für Automatikgetriebe verwendet. Dazu sind elektrische Schaltungsanordnungen vorgesehen, die mit weiteren Komponenten in Kontakt stehen. Beispielsweise werden Getriebesteuermodule innerhalb von Getriebegehäusen, und damit dem Getriebeöl ausgesetzt, angeordnet. Um die Leistungselektronik zu schützen, sind dafür z.B. eigene dichte Gehäuse vorgesehen. Beispielsweise beschreibt die EP 0 854 666 B1 ein Steuergerät, bei dem eine Leiterplatte zwischen einem Gehäusedeckel und einem Gehäuseboden angeordnet ist, so dass die Elektronik vor äußeren Einflüssen, insbesondere vor dem Getriebeöl, geschützt angeordnet ist. Ein weiteres Steuergerät ist aus der Druckschrift DE 10 2007 0142593 A1 bekannt.

Es hat sich jedoch gezeigt, dass dafür neben den elektronischen Bauteilen noch die zusätzlichen Deckelhälften erforderlich sind, und außerdem der Zusammenbau zeitaufwendig und komplex ist, um die erforderliche Dichtheit zu gewährleisten.

### Offenbarung der Erfindung

Mit einem Getriebesteuermodul, bzw. einem Getriebe, gemäß den unabhängigen Ansprüchen wird eine einfach herzustellende und bezüglich Dichtigkeit zuverlässige Anordnung einer Steuerungsschaltung zur Verfügung gestellt. Vorteilhafte Ausgestaltungen des Getriebesteuermoduls, des Getriebes, sind in den abhängigen Ansprüchen definiert.

Gemäß der Erfindung weist ein Getriebesteuermodul wenigstens eine sekundäre Leiterplatte auf, und zwischen der primären Leiterplatte und der wenigstens einen sekundären Leiterplatte sind mehrere Kontakte vorgesehen. Die sekundäre Leiterplatte weist eine flächige Wärmeabgabeseite und eine der Wärmeabgabeseite gegenüberliegende Montageseite auf, auf der wenigstens ein Bauelement angeordnet ist. Die sekundäre Leiterplatte ist wenigstens teilweise in dem Aufnahmevolumen angeordnet und mit der Montageseite der primären Leiterplatte zugewandt und mit der Wärmeabgabeseite mit der Bodenfläche wärmeleitend verbunden. Die Trägerplatte ist auf der zweiten Seite mit der primären Leiterplatte um das Aufnahmevolumen herum umlaufend verbunden und die Ausnehmung bildet einen durch die primäre Leiterplatte gegenüber der an das Getriebesteuermodul angrenzenden Umgebung abgeschlossenen und abgedichteten Hohlraum.

Dies ermöglicht einen einfachen Zusammenbau bei einer gleichzeitig zuverlässigen Abdichtung der auf der zweiten, bzw. sekundären Leiterplatte befindlichen Schaltungselemente. Das Ausbilden eines Hohlraums zur Aufnahme der Schaltungselemente und das Abdichten durch die primäre Leiterplatte bedeutet eine Reduktion der erforderlichen Teile, was zu einer weiteren Reduktion der Herstellungskosten beiträgt. Das Anordnen der sekundären Leiterplatte mit den Bauelementen in Richtung der primären Leiterplatte gewährleistet eine möglichst gute Wärmeabgabe aufgrund der nach außen, bzw. zur Trägerplatte hin weisenden flächigen Wärmeabgabeseite. Die Abfuhr von Wärme ist insbesondere mit den zunehmend leistungsfähigeren Schaltungen von Bedeutung, bei denen es zu einer relativ starken Wärmeentwicklung während des Betriebs kommen kann. Eine verbesserte Wärmeabfuhr trägt hier zu einer größeren Lebensdauer und zu einem zuverlässigerem Betrieb insgesamt bei. Die primäre Leiterplatte und die Trägerplatte bilden eine Art Sandwich, in dem die sekundäre Leiterplatte eingeschlossen ist. Die Leiterplatten werden auch als Schaltungstragvorrichtungen bezeichnet. Die Trägerplatte kann z.B. mit einer Verschraubung an einem Getriebebauteil befestigt werden. Dabei liegt die Trägerplatte möglichst großflächig an dem Getriebebauteil an, um eine gute Wärmeabfuhr zu gewährleisten. Bei dem Getriebebauteil handelt es sich beispielsweise um eine Hydraulikplatte. Die primäre Leiterplatte ist zumindest im Bereich der darunter befindlichen Ausnehmung und dem Anschlussbereich, dem Dichtungsbereich, als durchgehende Platte ohne Öffnungen oder Ausnehmungen ausgebildet. Die primäre Leiterplatte ist mit der Trägerplatte im Bereich des umlaufenden Bands auf der zweiten Seite verbunden. Der Begriff "umlaufend" bezieht sich hierbei vor allem auf die Abdichtung. Die Anpress- und Haltekräfte können punktuell oder umlaufend aufgebracht werden, z.B. durch eine umlaufende Verklebung.

Die primäre Leiterplatte weist z.B. eine primäre Schaltung auf, und die wenigstens eine sekundäre Leiterplatte weit z.B. eine sekundäre Schaltung auf. Das Aufnahmevolumen wird auch als Ausnehmung, Vertiefung oder Kavität bezeichnet. Die primäre Leiterplatte weist beispielsweise zusätzliche Leiterbahnen im Bereich der sekundären Leiterplatte auf. Die Kontakte verbinden die primäre Schaltung mit der sekundären Schaltung.

Gemäß der Erfindung sind die mehreren Kontakte wenigstens teilweise als Kaltkontakt-Pins vorgesehen. Kaltkontakt-Pins, oder Kaltkontakt-Stifte, sind kalt einpressbare Stifte, die eine sichere elektrische Kontaktierung ermöglichen. Die Kaltkontakt-Pins sind jeweils in eine Durchgangsöffnung in der sekundären Leiterplatte eingesetzt und ragen durch diese hindurch in eine Aufnahme der primären Leiterplatte. Die Aufnahmen in der primären Leiterplatte können beispielsweise als Sacklöcher ausgebildet sein. Die Kaltkontakt-Pins schließen beispielsweise mit der Außenseite der Wärmeabgabeseite der sekundären Leiterplatte wenigstens bündig ab, bzw. sind mit ihrem Ende leicht zurückversetzt eingesetzt. Die Durchgangsöffnung kann auf der Wärmeabgabeseite mit einem Isolier- bzw. Abdeckelement verschlossen sein. Bei Kaltkontakt-Pins kann für die primäre Leiterplatte und die sekundäre Leiterplatte ein möglichst identisches Wärmeausdehnungsverhalten vorgesehen sein, um die Kontakte nicht auf Scherung zu beanspruchen.

Die Trägerplatte kann eine massive Platte sein, in welcher das Aufnahmevolumen als eine Ausnehmung ausgebildet ist. Die Trägerplatte kann aber auch eine profilierte Platte sein, in welcher das Aufnahmevolumen als eine Vertiefung ausgebildet ist. Die Trägerplatte kann im Bereich der anliegenden sekundären Leiterplatte eine wärmeleitende Einlage aufweisen, z.B. eine Metallplatte in einem Kunststoffmetallverbund. Die wärmeleitende Einlage kann beispielsweise auch durch wärmeleitende Fasern in einer Kunststoffmatrix erfolgen, z.B. durch entsprechende Kohlefaserstränge in einem faserverstärkten Kunststoff.

Die primäre Leiterplatte kann eine durchgehende Entlüftungsbohrung aufweisen, mit welcher das Aufnahmevolumen mit der angrenzenden Umgebung temporär verbindbar ist. Die Entlüftungsbohrung ist in einem montierten Zustand verschlossen. Beispielsweise wird die Entlüftungsbohrung mit einem Lötpunkt verschlossen.

Zwischen der primären Leiterplatte und der sekundären Leiterplatte können Abstandselemente vorgesehen sein. Beispielsweise kommen z.B. geklebte Abstandshalter oder druckbelastbare Bauelemente als Abstandselemente in Frage. Der Raum zwischen der primären Leiterplatte und den Bauelementen auf der sekundären Leiterplatte kann mit einem wärmeleitenden Material gefüllt sein, z.B. mit einem Wärmeleitkleber oder einem Gel.

In der primären Leiterplatte können außerdem auch thermische Vias vorgesehen sein, um einen verbesserten Wärmeaustausch zwischen dem Aufnahmevolumen und der Umgebung zu gewährleisten. Die thermischen Vias können auf der Außen- und/oder Innenseite der primären Leiterplatte mit einer Wärmeleitfläche, z.B. aus Kupfer, verbunden sein.

Zum Anschluss von außenliegenden Bauelementen oder Verbindungen, wie z.B. Sensoren, Steckern, etc. kann die Trägerplatte eine oder mehrere Durchlassöffnungen aufweisen, um die auf der Außenseite angeordneten Bauelemente auf der primären Leiterplatte mit einer Lötverbindung zu befestigen, die an der Seite des Leiterplatte angeordnet ist, welche der Trägerplatte zugewandt ist und an dieser anliegt, wozu das Loch, bzw. die Durchgangsöffnungen in der Trägerplatte vorgesehen sind. Statt der Durchgangsöffnungen mit Lötverbindungen können auch andere Anschluss- und Verbindungstechniken vorgesehen sein, z.B. SMD-Verbindungen, Pins, bzw. Stifte, etc.

Die primäre Leiterplatte kann auf der der sekundären Leiterplatte zugewandten Seite wenigstens eine Kavität aufweisen, in welche Bauelemente der sekundären Leiterplatte ragen, die auf der Montageseite vorgesehen sind. Beispielsweise sind mehrere sekundäre Leiterplatten vorgesehen und mehrere Kavitäten. Die Kavitäten eignen sich z.B. für flache Bauelemente, da die Dicke der primären Leiterplatte begrenzt ist, wenn aus wirtschaftlichen Gründen auf handelsübliche mehrschichtige Leiterplatten zurückgegriffen werden soll. Die Kavitäten bieten den Vorteil, dass die Bauhöhe des Getriebesteuermoduls insgesamt auf ein Minimum reduziert werden kann.

Die Trägerplatte kann einen die umlaufende Wandung umschließenden Randbereich aufweisen, und in dem Randbereich kann eine umlaufende Dichtung vorgesehen sein. Die umlaufende Dichtung kann beispielsweise eine abdichtende Verklebung sein oder eine umlaufende Dichtung mit einer zusätzlichen Verklebung. Die Dichtung kann in eine Nut eingelegt sein, flach aufgelegt, aufvulkanisiert, aufgetragen oder aufgeklebt sein.

Gemäß einem zweiten Aspekt weist ein Getriebe für ein Kraftfahrzeug eine Getriebeeinrichtung, ein Getriebegehäuse und ein Getriebesteuermodul nach einem der vorhergehend genannten Beispiele auf. Die Getriebeeinrichtung ist von dem Getriebegehäuse umschlossen und das Getriebesteuermodul ist mit der Trägerplatte an einer Innenseite des Getriebegehäuses befestigt. Aufgrund der erfindungsgemäßen Ausgestaltung des Getriebesteuermoduls wird so ein Getriebe zur Verfügung gestellt, bei dem die Dichtigkeit gewährleistet ist, bei gleichzeitig verringertem Montage- bzw. Herstellungsaufwand. Das Befestigen an der Trägerplatte gewährleistet eine verbesserte Wärmeabfuhr, in Kombination mit der bereits oberhalb erwähnten Anordnung der sekundären Leiterplatte über die Trägerplatte.

Gemäß einem weiteren Aspekt kann z.B. ein Verfahren für den Zusammenbau eines Getriebesteuermoduls folgende Schritte aufweisen: a) Vorsehen einer primären Trägerplatte, die auf einer ersten Seite an einem Getriebebauteil befestigbar ist und auf einer zweiten Seite, die der ersten Seite gegenüberliegt, ein Aufnahmevolumen mit einer Bodenfläche und einer umlaufenden Wandung bildet; b) Vorsehen einer primären Leiterplatte, die flächig und plattenförmig ausgebildet ist und mit Anschlüssen für eine externe Verbindung versehen ist; und c) Befestigen der primären Leiterplatte an der Trägerplatte. Es ist vorgesehen, dass in Schritt b) wenigstens eine sekundäre Leiterplatte vorgesehen wird, die eine flächige Wärmeabgabeseite und eine der Wärmeabgabeseite gegenüberliegende Montageseite aufweist, auf der mehrere Bauelemente angeordnet sind. Zwischen der primären Leiterplatte und der wenigstens einen sekundären Leiterplatte sind mehrere Kontakte vorgesehen. Vor Schritt c) wird die sekundäre Leiterplatte wenigstens teilweise in dem Aufnahmevolumen angeordnet und mit der Montageseite der primären Leiterplatte zugewandt. In Schritt c) wird die sekundäre Leiterplatte mit der Wärmeabgabeseite mit der Bodenfläche wärmeleitend verbunden, und die Trägerplatte wird auf der zweiten Seite mit der primären Leiterplatte um das Aufnahmevolumen herum umlaufend verbunden, so dass die Ausnehmung durch die primäre Leiterplatte einen gegenüber der an das Getriebesteuermodul angrenzenden Umgebung abgeschlossenen und abgedichteten Hohlraum bildet. Beispielsweise ist nach Schritt c) ein Aushärteschritt d) vorgesehen, in dem Wärme zugeführt wird. Zumindest während eines Teils des Aushärtens ist eine durchgehende Lüftungsbohrung vorgesehen, mit welcher das Aufnahmevolumen mit der angrenzenden Umgebung temporär verbunden wird, z.B. durch die primäre Leiterplatte. Die Entlüftungsbohrung kann aber auch in der Trägerplatte vorgesehen sein. Die Entlüftungsbohrung wird im Anschluss an das Aushärten verschlossen.

Mögliche Ausgestaltungen und Vorteile der hierin vorgeschlagenen Erfindung werden teilweise mit Bezug auf Getriebesteuermodule und teilweise mit Bezug auf Getriebe beschrieben. Ein Fachmann wird erkennen, dass die einzelnen Merkmale in beliebiger Weise miteinander kombiniert werden können und auch von dem Getriebesteuermodul auf das Getriebe, bzw. auch umgekehrt übertragen werden können, um auf diese Weise Synergieeffekte erreichen zu können.

### Kurze Beschreibung der Zeichnungen

Nachfolgend werden beispielhafte Ausführungsformen mit Bezug auf die beigefügten Zeichnungen weiter erläutert, wobei weder die Zeichnungen noch die Beschreibung als einschränkend auszulegen sind.
- Fig. 1: zeigt einen schematischen Querschnitt durch ein Getriebesteuermodul in einer ersten Ausführungsform.
- Fig. 2: zeigt eine weitere Ausführungsform eines Getriebesteuermoduls in einem Querschnitt.
- Fig. 3: zeigt eine noch weitere Ausführungsform eines Getriebesteuermoduls in einem Querschnitt.
- Fig. 4: zeigt eine weitere Ausführungsform eines Getriebesteuermoduls in einem Querschnitt.
- Fig. 5: zeigt ein Beispiel für ein Getriebe für ein Kraftfahrzeug in einem schematischen Querschnitt.
- Fig. 6: zeigt ein Beispiel für ein Verfahren für den Zusammenbau eines Getriebesteuermoduls.
- Fig. 7: zeigt eine schematische Darstellung in Zusammenhang mit einem Beispiel für einen Montageablauf.
- Fig. 8a: bis 8d zeigen weitere Aspekte im Zusammenhang mit dem Zusammenbau eines Getriebesteuermoduls gemäß einem Beispiel.
- Fig. 9: zeigt einen Querschnitt durch einen Ausschnitt eines Getriebesteuermoduls gemäß einem weiteren Ausführungsbeispiel.

Die Figuren sind lediglich schematisch und nicht maßstabsgetreu dargestellt. Gleiche Bezugszeichen bezeichnen gleiche oder gleich wirkende Komponenten.

### Ausführungsformen der Erfindung

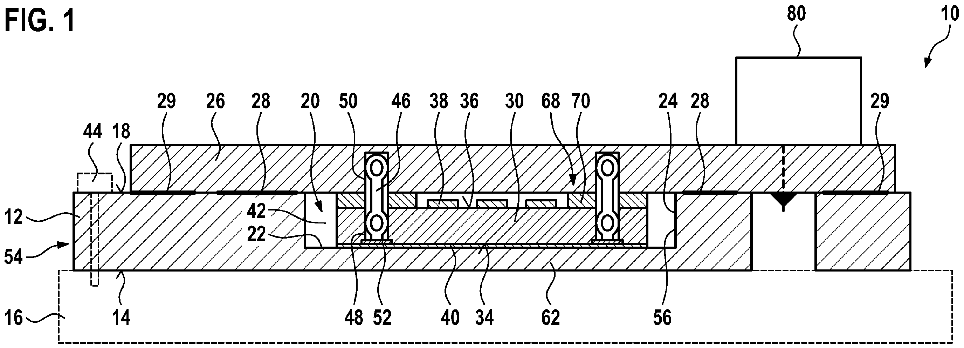

Fig. 1 zeigt ein Getriebesteuermodul 10 eines Kraftfahrzeuggetriebes, mit einer Trägerplatte 12, die auf einer ersten Seite 14 an einem Getriebebauteil befestigt werden kann, das in Fig. 1 mit Bezugszeichen 16 versehen ist und gestrichelt angedeutet ist. Die Trägerplatte bildet auf einer zweiten Seite 18, die der ersten Seite 14 gegenüberliegt, ein Aufnahmevolumen 20 mit einer Bodenfläche 22 und einer umlaufenden Wandung 24. Außerdem ist eine primäre Leiterplatte 26 vorgesehen, die flächig und plattenförmig ausgebildet ist und mit Anschlüssen (nicht näher gezeigt) für eine externe Verbindung versehen ist. Die primäre Leiterplatte 26 ist an der Trägerplatte 12 befestigt, beispielsweise mittels eines Klebers 28, der beispielsweise die Abdichtung übernimmt. Außerdem kann ein zusätzlicher Kleber 29 vorgesehen sein. Außerdem ist eine sekundäre Leiterplatte 30 vorgesehen. Zwischen der primären Leiterplatte 26 und der wenigstens einen sekundären Leiterplatte 30 sind mehrere Kontakte 32 vorgesehen. Die sekundäre Leiterplatte 30 weist eine flächige Wärmeabgabeseite 34 und eine der Wärmeabgabeseite gegenüberliegende Montageseite 36 auf. Auf der Montageseite 36 ist wenigstens ein Bauelement 38 angeordnet, z.B. mehrere Bauelemente 38. Die sekundäre Leiterplatte 30 ist wenigstens teilweise in dem Aufnahmevolumen 20 angeordnet und mit der Montageseite 36 der primären Leiterplatte 26 zugewandt. Außerdem ist die sekundäre Leiterplatte 30 mit der Wärmeabgabeseite 34 mit der Bodenfläche 22 wärmeleitend verbunden, beispielsweise mittels eines wärmeleitenden Klebers 40, der z.B. auch elektrisch isolierend ausgebildet sein kann. Die Trägerplatte 12 ist auf der zweiten Seite 18 mit der primären Leiterplatte 26 um das Aufnahmevolumen 20 herum umlaufend verbunden. Dadurch bildet die Ausnehmung 20 einen durch die primäre Leiterplatte 26 gegenüber der an das Getriebesteuermodul angrenzenden Umgebung abgeschlossenen und abgedichteten Hohlraum 42.

Die Trägerplatte 12 ist beispielsweise mittels einer Verschraubung 44, gestrichelt dargestellt, mit dem Getriebebauteil 16 verbunden, bei dem es sich z.B. um eine Hydraulikplatte handeln kann.

Die mehreren Kontakte 32 sind wenigstens teilweise als Kaltkontakt-Pins 46 vorgesehen. Dazu sind die Kaltkontakt-Pins 46 jeweils in eine Durchgangsöffnung 48 in der sekundären Leiterplatte 30 eingesetzt und ragen durch diese hindurch in eine Aufnahme 50 der primären Leiterplatte 26. Die Durchgangsöffnung 48 ist auf der Wärmeabgabeseite 34 mit einem Isolier- bzw. Abdeckelement 52 verschlossen. Beispielsweise können die primären und sekundären Leiterplatten auf hochpräzisen PCB-Bohrmaschinen, vorzugsweise Laserbohrern, gebohrt werden, um eine hochpräzise Fluchtung der Kaltkontakt-Pins, oder auch Kaltkontakt-Stifte, zu ermöglichen. Kaltkontakt-Pins sind kalt einpressbare Kontakte, die eine sichere elektrische Kontaktierung ermöglichen. Ein Abstandshalter zwischen den beiden Leiterplatten stellt sicher, dass Bauelemente der sekundären Leiterplatte nicht mit der primären Leiterplatte kollidieren. Beide Leiterplatten werden präzise zueinander ausgerichtet, beispielsweise in einer Vorrichtung oder über Passstifte in beiden Leiterplatten und dem Abstandshalter. Anschließend werden die Kaltkontaktstifte eingepresst, die vorzugsweise bündig zur Oberfläche der Leiterplatte verschwinden, oder wenn sie zu lang sind, direkt oberhalb der Leiterplattenoberfläche abgetrennt werden, um dann beispielsweise noch 0,1 bis 0,3 mm nachgeschoben zu werden, um sicher zumindest bündig mit Leiterplattenoberfläche zu sein. Die Kaltkontakt-Stifte ermöglichen beispielsweise auch eine Verbindung an Stellen, die nicht am Rand der Leiterplatte liegen, sondern mitten in der Fläche, was Vorteile beim Entflechten der Schaltungen und der Leiterplatten bietet, z. B. Kosten und Bauraumvorteil.

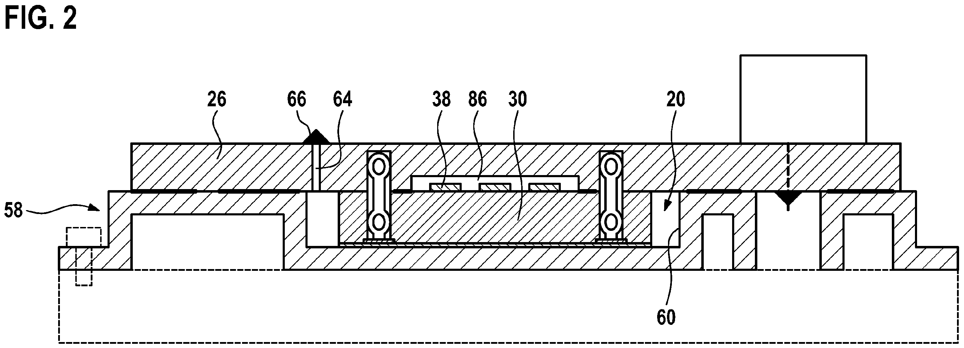

Die Trägerplatte 12 kann beispielsweise eine massive Platte 54 sein, in welcher das Aufnahmevolumen 20 als eine Ausnehmung 56 ausgebildet, bzw. eingeschnitten ist, wie in Fig. 1 gezeigt. Die Trägerplatte 12 kann aber auch eine profilierte Platte 58 sein, in welcher das Aufnahmevolumen 20 als eine Vertiefung 60 ausgebildet ist, wie dies in Fig. 2 gezeigt ist. Die Trägerplatte 12 kann beispielsweise aus einem wärmeleitenden Metall hergestellt sein, oder auch aus einem Kunststoff. Wie in Fig. 1 angedeutet, kann zumindest in einem Teilbereich der anliegenden sekundären Leiterplatte 30 eine wärmeleitende Einlage 62 vorgesehen sein, die sich auch über einen größeren Bereich erstrecken kann, als der in Fig. 1 gezeigte. Beispielsweise kann die wärmeleitende Einlage 62 eine Metallplatte in einem Kunststoff-Metall-Verbund sein. Die wärmeleitende Einlage 62 kann auch bei der profilierten Platte 58 vorgesehen sein.

Wie in Fig. 2 gezeigt ist, kann die primäre Leiterplatte 26 eine durchgehende Entlüftungsbohrung 64 aufweisen, mit der das Aufnahmevolumen 20 mit der angrenzenden Umgebung temporär verbunden werden kann. In montiertem Zustand ist die Entlüftungsbohrung verschlossen, beispielsweise mit einem Lötpunkt 66. Die Entlüftungsbohrung 64 kann beispielsweise während des Aushärtens, z.B. für die Dichtungen und die Klebungen, einen Überdruck im Bereich der Ausnehmung 20 vermeiden.

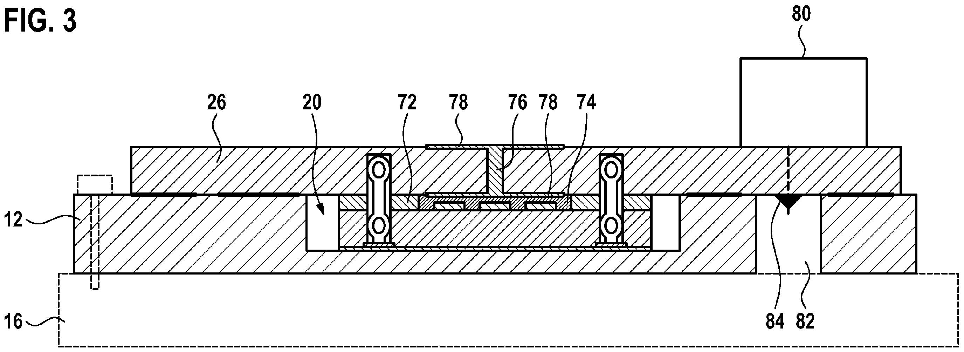

Um einen ausreichenden Bauraum für die Anordnung der Bauelemente 38 zur Verfügung zu stellen, können zwischen der primären Leiterplatte 26 und der sekundären Leiterplatte 30 Abstandselemente 68 vorgesehen sein. Beispielsweise sind dafür Abstandshalter 70 vorgesehen, wie dies in Fig. 1 gezeigt ist, oder auch druckbelastbare Bauelemente 72, wie dies in Fig. 3 gezeigt ist. Der Raum zwischen der primären Leiterplatte 26 und der Bauelemente 38 auf der sekundären Leiterplatte 30 kann mit einem wärmeleitenden Material 74 gefüllt sein, z.B. mit einem wärmeleitfähigen Gel, wie dies in Fig. 3 angedeutet ist. Die Abstandshalter 70 können beispielsweise verklebt sein.

Wie ebenfalls in Fig. 3 gezeigt ist, können in der primären Leiterplatte 26 auch thermische Vias 76 vorgesehen sein, um einen verbesserten Wärmeaustausch zwischen dem Aufnahmevolumen 20 und der Umgebung zu gewährleisten. Beispielsweise sind dazu thermische Vias mit Wärmeleitflächen 78 auf der Innen- und/oder Außenseite verbunden, die beispielsweise aus Kupfer bestehen. Zum Anschluss von außenliegenden Bauelementen oder Verbindungen, beispielsweise Sensoren oder Stecker, in den Figuren schematisch mit einem einfachen Kasten 80 angedeutet, kann die Trägerplatte 12 eine oder mehrere Durchgangsöffnungen 82 aufweisen, um die auf der Außenseite angeordneten Bauelemente 80 auf der primären Leiterplatte 26 mit einer Lötverbindung 84, z.B. einer Tiegellötung, zu befestigen. Diese ist an der Seite der Leiterplatte 26 angeordnet, die der Trägerplatte 12 zugewandt ist und an dieser anliegt. Daher ist das Loch, bzw. die Durchgangsöffnung 82 vorgesehen in der Trägerplatte 12, um die Lötverbindung vorzunehmen, bevor die Trägerplatte 12 mit dem Getriebebauteil 16 verbunden wird. Statt der Durchgangsöffnungen 82 mit den Lötverbindungen 84 können auch andere Anschluss- und Verbindungstechniken vorgesehen sein, z.B. SMD-Verbindungen, Pins oder Stifte, etc.

Die primäre Leiterplatte 26 kann, wie in Fig. 2 angedeutet, auf der der sekundären Leiterplatte 30 zugewandten Seite wenigstens eine Kavität 86 aufweisen, in welche Bauelemente 38 der sekundären Leiterplatte 30 ragen, die auf der Montageseite 36 vorgesehen sind.

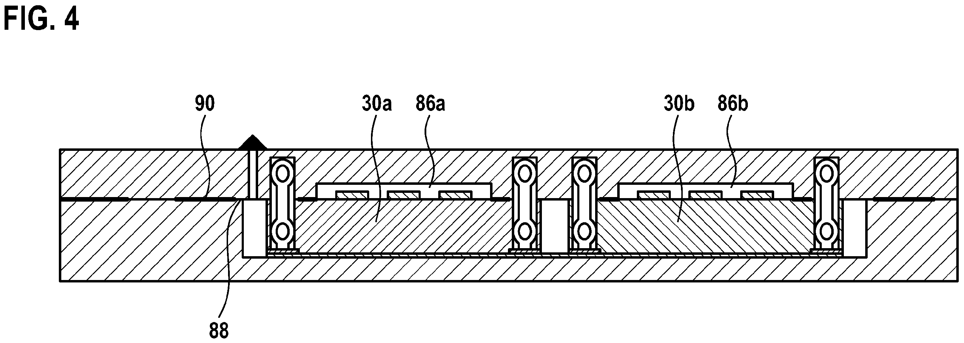

Gemäß dem in Fig. 4 gezeigten Beispiel können auch mehrere sekundäre Leiterplatten 30, in Fig. 4 als 30a und 30b bezeichnet, vorgesehen sein. Diese mehreren sekundären Leiterplatten 30 können beispielsweise auch für Varianten vorgesehen sein, bei denen Abstandshalter 68 vorgesehen sind, statt den mehreren Kavitäten in Fig. 4, mit Bezugszeichen 86a und 86b bezeichnet. Bei den beiden sekundären Leiterplatten 30a, 30b handelt es sich beispielsweise um eine Transmissionssteuereinheit, *transmission control unit* TCU, und eine zweite Elektronik, z.B. um ein Logikteil und eine Leistungselektronik.

Jedenfalls bildet die Trägerplatte 12 einen die umlaufende Wandung 24 umschließenden Randbereich, in Fig. 4 mit Bezugszeichen 88 angedeutet, wobei in dem Randbereich 88 eine umlaufende Dichtung 90 vorgesehen ist, beispielsweise in Form der bereits erwähnten Verklebung 28. Die umlaufende Dichtung kann beispielsweise eine abdichtende Verklebung sein oder eine umlaufende Dichtung mit einer zusätzlichen Verklebung, wie in den Figuren gezeigt. Die Dichtung kann aber auch in einer Nut eingelegt sein (nicht näher gezeigt), flach aufgelegt, aufvulkanisiert, aufgetragen oder aufgeklebt sein (ebenfalls nicht näher gezeigt).

Die sekundäre Leiterplatte 30 weist beispielsweise eine TCU auf. Die TCU-Leiterplatte ist direkt zwischen der Modul-Leiterplatte in Form der primären Leiterplatte und der Trägerplatte dicht verbaut, ohne zusätzlichen Deckel mit Dichtungen. Die sekundäre Leiterplatte kann an der primären Leiterplatte verklebt befestigt sein. Die Bauelemente 38 können eine Höhe im Bereich von bis zu 3 mm aufweisen, wenn diese gegen einen direkten Kontakt mit der Modul-Leiterplatte, d.h. der primären Leiterplatte geschützt sein sollen. Die primäre Leiterplatte ist beispielsweise 1,5 bis 2,5 mm dick, während die Trägerplatte 12 ca. 3 mm dick sein kann. Die profilierte Platte 58 kann beispielsweise als geprägte, tiefgezogene oder auch gefräste Platte ausgebildet sein.

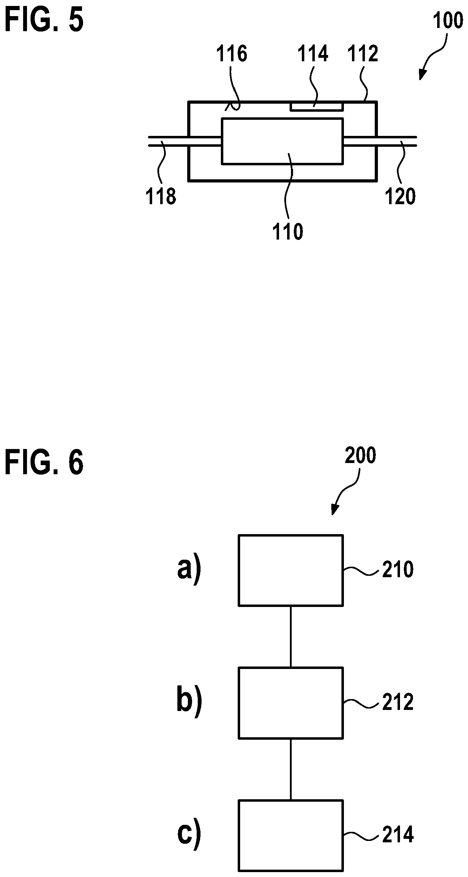

In Fig. 5 ist ein Getriebe 100 für ein Kraftfahrzeug gezeigt, das eine Getriebeeinrichtung 110, ein Getriebegehäuse 112 und ein Getriebesteuermodul 114 aufweist. Das Getriebesteuermodul 114 ist als ein Getriebesteuermodul 10 nach einem der vorhergehend beschriebenen Ausführungsbeispiele ausgebildet. Die Getriebeeinrichtung 110 ist von dem Getriebegehäuse 112 umschlossen, und das Getriebesteuermodul 114, bzw. Getriebesteuermodul 10, ist mit Trägerplatte an einer Innenseite 116 des Getriebegehäuses 112 befestigt. In Fig. 5 ist schematisch noch ein Antriebsstrang 118 sowie ein Abtriebsstrang 120 dargestellt. Es sei darauf hingewiesen, dass die Darstellung in Fig. 5 rein schematisch ist.

In Fig. 6 ist ein Beispiel für ein Verfahren 200 für den Zusammenbau eines Getriebesteuermoduls gezeigt. In einem ersten Schritt 210 wird eine primäre Trägerplatte vorgesehen, die auf einer ersten Seite an einem Getriebebauteil befestigbar ist und auf einer zweiten Seite, die der ersten Seite gegenüberliegt, ein Aufnahmevolumen mit einer Bodenfläche und einer umlaufenden Wandung bildet. In einem zweiten Schritt 212 wird eine primäre Leiterplatte vorgesehen, die flächig und plattenförmig ausgebildet ist und mit Anschlüssen für eine externe Verbindung versehen ist. In einem dritten Schritt 214 wird die primäre Leiterplatte an der Trägerplatte befestigt. Außerdem ist vorgesehen, dass in dem zweiten Schritt 212 wenigstens eine sekundäre Leiterplatte vorgesehen wird, die eine flächige Wärmeabgabeseite und eine der Wärmeabgabeseite gegenüberliegende Montageseite aufweist, auf der mehrere Bauelemente angeordnet sind; zwischen der primären Leiterplatte und der wenigstens einen sekundären Leiterplatte sind mehrere Kontakte vorgesehen. Im dritten Schritt 214 wird die sekundäre Leiterplatte wenigstens teilweise in dem Aufnahmevolumen angeordnet und mit der Montageseite der primären Leiterplatte zugewandt. Im dritten Schritt 214 wird die sekundäre Leiterplatte mit der Wärmeabgabeseite mit der Bodenfläche wärmeleitend verbunden, und die Trägerplatte wird auf der zweiten Seite mit der primären Leiterplatte um das Aufnahmevolumen herum umlaufend verbunden, so dass die Ausnehmung durch die primäre Leiterplatte einen gegenüber der an das Getriebesteuermodul angrenzenden Umgebung abgeschlossenen und abgedichteten Hohlraum bildet. Der erste Schritt 210 wird auch als Schritt a) bezeichnet, der zweite Schritt 212 als Schritt b), und der dritte Schritt 214 als Schritt c).

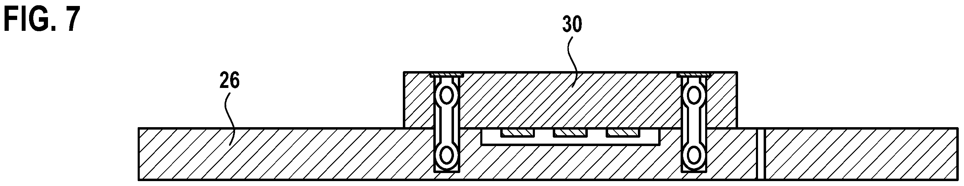

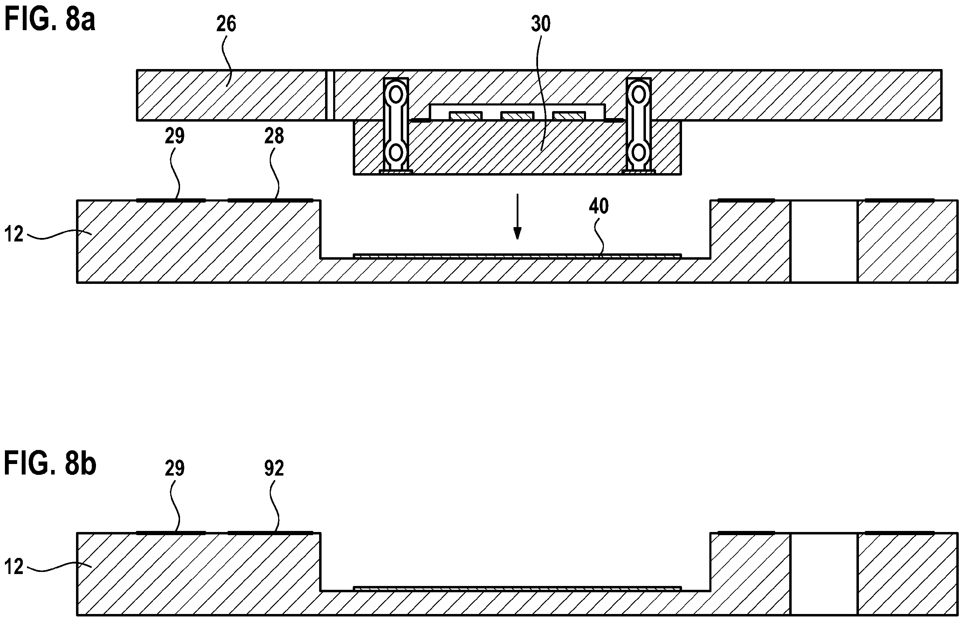

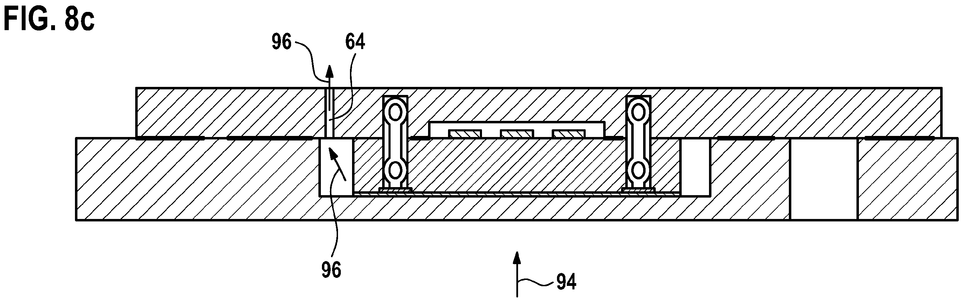

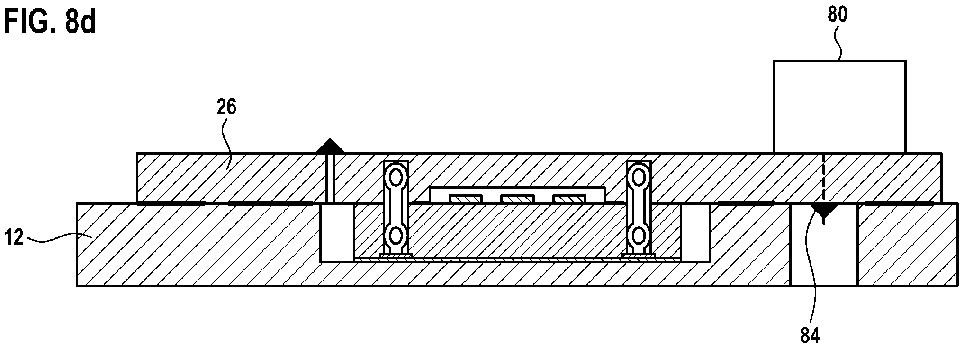

In Fig. 7 ist ein Zustand aus einem Montageablauf gezeigt, bei dem die sekundäre Leiterplatte 30 mit der primären Leiterplatte 26 verbunden wird, wobei anschließend die verbundenen Leiterplatten gedreht werden, um, wie in Fig. 8a angedeutet, mit der Trägerplatte 12 verbunden zu werden. In Fig. 8a ist dafür der bereits erwähnte Kleber 29 zur Befestigung und der bereits erwähnte Kleber 28 zur Dichtung vorgesehen, wohingegen in Fig. 8b eine Variante gezeigt ist, bei der neben dem Befestigungskleber 29 anstelle des Dichtklebers 28 eine Elastomer-Dichtung 92 vorgesehen ist. In Fig. 8c ist ein Aushärtevorgang gezeigt, bei dem beispielsweise Wärme 94 zugeführt wird, so dass über die Entlüftungsbohrung 64 Überdruck entweichen kann, wie dies mit Pfeilen 96 angedeutet ist. Anschließend kann, wie in Fig. 8d gezeigt, das Vorsehen der sonstigen Bauteile 80 erfolgen, die beispielsweise mittels der bereits erwähnten Tiegellötung befestigt werden, d.h. durch die Lötpunkte 84.

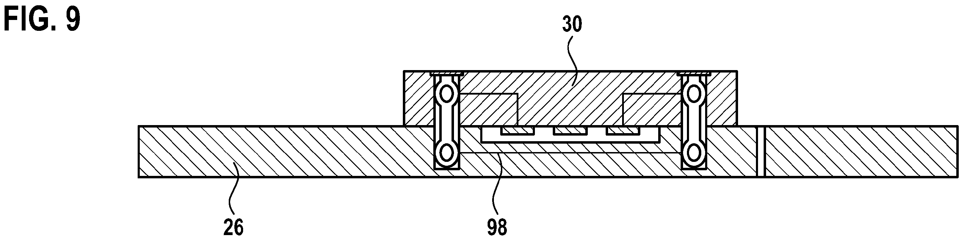

In Fig. 9 ist gezeigt, dass beispielsweise eine Entflechtung der Schaltung auf der sekundären Leiterplatte 26 möglich ist. Beispielsweise können Leiterbahnen 98 im Bereich der primären Leiterplatte 26 vorgesehen werden.

Gemäß einem weiteren, nicht gezeigten Ausführungsbeispiel der Erfindung kann beispielsweise die TCU als HDI-PCB-TCU, *high density interconnect printed circuit board,* ausgebildet sein, in Verbindung mit der bereits erwähnten Leistungselektronik, beispielsweise als DBC-Schaltung, *direct-bonded-copper-*Schaltung. Da im Bereich der primären Leiterplatte 26 keine Ausschnitte und Durchbrüche, bzw. nur minimale Kavitäten vorgesehen sind, kann die komplette Grundfläche der primären Leiterplatte zur Entflechtung, d.h. Leitungsführung, Leiterbahnen, etc. genutzt werden, d.h. auch die über bzw. unter der sekundären Leiterplatte liegenden Flächenanteile. Dadurch lassen sich signifikant Vorteile in der gesamten Modulleitungsentflechtung erreichen. Beispielsweise lässt sich auch die TCU-PCB leichter entflechten, da einzelne TCU-Anschluss-Pads außerhalb der TCU, nämlich über bzw. unterhalb der TCU verbunden werden können, statt diese über eine Lage der TCU-PCB zu entflechten. Mit anderen Worten, es lassen sich damit ein oder zwei Lagen der teuren TCU-HDI-PCB einsparen.

## Patentansprüche

1. Getriebesteuermodul (10) eines Kraftfahrzeuggetriebes, mit einer Trägerplatte (12), die auf einer ersten Seite (14) an einem Getriebebauteil befestigbar ist und auf einer zweiten Seite (18), die der ersten Seite gegenüberliegt, ein Aufnahmevolumen (20) mit einer Bodenfläche (22) und einer umlaufenden Wandung (24) bildet, und einer primären Leiterplatte (26), die flächig und plattenförmig ausgebildet ist und mit Anschlüssen für eine externe Verbindung versehen ist; wobei die primäre Leiterplatte an der Trägerplatte befestigt ist;
wobei wenigstens eine sekundäre Leiterplatte (30) vorgesehen ist;
wobei zwischen der primären Leiterplatte und der wenigstens einen sekundären Leiterplatte mehrere Kontakte vorgesehen sind; und die sekundäre Leiterplatte eine flächige Wärmeabgabeseite (34) und eine der Wärmeabgabeseite gegenüberliegende Montageseite (36) aufweist, auf der wenigstens ein Bauelement (38) angeordnet ist;
wobei die sekundäre Leiterplatte wenigstens teilweise in dem Aufnahmevolumen angeordnet ist und mit der Montageseite der primären Leiterplatte zugewandt ist und mit der Wärmeabgabeseite mit der Bodenfläche wärmeleitend verbunden ist; und die Trägerplatte auf der zweiten Seite mit der primären Leiterplatte um das Aufnahmevolumen herum umlaufend verbunden ist und die Ausnehmung einen durch die primäre Leiterplatte gegenüber der an das Getriebesteuermodul angrenzenden Umgebung abgeschlossenen und abgedichteten Hohlraum (42) bildet,
**dadurch gekennzeichnet, dass**
die mehreren Kontakte wenigstens teilweise als Kaltkontakt-Pins (46) vorgesehen sind, und
die Kaltkontakt-Pins jeweils in eine Durchgangsöffnung (48) in der sekundären Leiterplatte (30) eingesetzt sind und durch diese hindurch in eine Aufnahme (50) der primären Leiterplatte (26) ragen, wobei die Durchgangsöffnungen (48) auf der Wärmeabgabeseite (34) mit einem Abdeckelement (52) verschlossen sind.

2. Getriebesteuermodul nach Anspruch 1, wobei die Trägerplatte
i) eine massive Platte (54) ist, in welcher das Aufnahmevolumen als eine Ausnehmung (56) ausgebildet ist; oder
ii) eine profilierte Platte (58), in welcher das Aufnahmevolumen als eine Vertiefung (60) ausgebildet ist.

3. Getriebesteuermodul nach einem der vorhergehenden Ansprüche, wobei die primäre Leiterplatte eine durchgehende Entlüftungsbohrung (64) aufweist, mit welcher das Aufnahmevolumen mit der angrenzenden Umgebung temporär verbindbar ist; wobei die Entlüftungsbohrung in einem montierten Zustand verschlossen ist.

4. Getriebesteuermodul nach einem der vorhergehenden Ansprüche, wobei zwischen der primären Leiterplatte und der sekundären Leiterplatte Abstandselemente (68) vorgesehen sind.

5. Getriebesteuermodul nach einem der vorhergehenden Ansprüche, wobei die primäre Leiterplatte auf der der sekundären Leiterplatte zugewandten Seite wenigstens eine Kavität (86) aufweist, in welche Bauelemente der sekundären Leiterplatte ragen, die auf der Montageseite vorgesehen sind.

6. Getriebesteuermodul nach einem der vorhergehenden Ansprüche, wobei Entflechtungs-Leiterbahnen (98) auf der primären Leiterplatte im Überlappungsbereich mit der sekundären Leiterplatte vorgesehen sind zur Entflechtung der Schaltung auf der sekundären Leiterplatte.

7. Getriebe (100) für ein Kraftfahrzeug, mit einer Getriebeeinrichtung (110), einem Getriebegehäuse (112) und einem Getriebesteuermodul (114, 10) nach einem der vorhergehenden Ansprüche; wobei die Getriebeeinrichtung von dem Getriebegehäuse umschlossen ist; und wobei das Getriebesteuermodul mit der Trägerplatte an einer Innenseite (116) des Getriebegehäuses befestigt ist.

## Claims

1. Gearbox control module (10) of a motor vehicle gearbox, having a support plate (12) which is fastenable on a first side (14) to a gearbox component and which, on a second side (18) situated opposite the first side, forms a receiving volume (20) with a base surface (22) and with an encircling wall (24), and having a primary printed circuit board (26) which is of areal and plate-like form and which is equipped with terminals for an external connection; wherein the primary printed circuit board is fastened to the support plate;
wherein at least one secondary printed circuit board (30) is provided;
wherein multiple contacts are provided between the primary printed circuit board and the at least one secondary printed circuit board; and the secondary printed circuit board has an areal heat-release side (34) and an installation side (36) which is situated opposite the heat-release side and on which at least one component (38) is arranged; wherein the secondary printed circuit board is arranged at least partially in the receiving volume and faces, by way of the installation side, toward the primary printed circuit board and is connected, by way of the heat-release side, in a heat-conducting manner to the base surface; and the support plate is, on the second side, connected to the primary printed circuit board in encircling fashion around the receiving volume, and the recess forms a cavity (42) which is closed off and sealed off with respect to the surroundings adjacent to the gearbox control module by the primary printed circuit board, **characterized in that**
the multiple contacts are at least partially provided as cold contact pins (46), and
the cold contact pins are in each case inserted into a passage opening (48) in the secondary printed circuit board (30) and project through the latter into a receptacle (50) of the primary printed circuit board (26), wherein the passage openings (48) are closed off, on the heat-release side (34), by way of a cover element (52).

2. Gearbox control module according to Claim 1, wherein the support plate
i) is a solid plate (54) in which the receiving volume is formed as a recess (56); or
ii) is a profiled plate (58) in which the receiving volume is formed as a depression (60).

3. Gearbox control module according to one of the preceding claims, wherein the primary printed circuit board has a ventilation bore (64) which extends all the way through and by way of which the receiving volume is temporarily connectable to the adjacent surroundings, wherein the ventilation bore is closed off in an installed state.

4. Gearbox control module according to one of the preceding claims, wherein spacer elements (68) are provided between the primary printed circuit board and the secondary printed circuit board.

5. Gearbox control module according to one of the preceding claims, wherein the primary printed circuit board has, on the side facing toward the secondary printed circuit board, at least one cavity (86) into which components of the secondary printed circuit board, which are provided on the installation side, project.

6. Gearbox control module according to one of the preceding claims, wherein disentanglement conductor tracks (98) are provided on the primary printed circuit board in the region of overlap with the secondary printed circuit board for the purposes of disentanglement of the circuit on the secondary printed circuit board.

7. Gearbox (100) for a motor vehicle, having a gearbox device (110), a gearbox housing (112) and a gearbox control module (114, 10) according to one of the preceding claims, wherein the gearbox device is enclosed by the gearbox housing, and wherein the gearbox control module is fastened by way of the support plate to an inner side (116) of the gearbox housing.

## Revendications

1. Module de commande de boîte de vitesses (10) d'une boîte de vitesses de véhicule automobile, comprenant une plaque porteuse (12) qui, sur un premier côté (14), peut être fixée à un élément structurel de boîte de vitesses et, sur un deuxième côté (18), lequel est opposé au premier côté, forme un volume d'accueil (20) comprenant une surface de fond (22) et une paroi (24) circonférentielle, et un circuit imprimé primaire (26) qui est de configuration plane et en forme de plaque et qui est pourvu de bornes pour une liaison externe ; le circuit imprimé primaire étant fixé à la plaque porteuse ;
au moins un circuit imprimé secondaire (30) étant présent ;
plusieurs contacts étant présents entre le circuit imprimé primaire et l'au moins un circuit imprimé secondaire ; et le circuit imprimé secondaire possédant un côté de dissipation de chaleur (34) plat et un côté de montage (36) opposé au côté de dissipation de chaleur, sur lequel est disposé au moins un composant (38) ;
le circuit imprimé secondaire étant disposé au moins partiellement dans le volume d'accueil et faisant face au côté de montage du circuit imprimé primaire et étant relié en conduction thermique à la surface de fond avec le côté de dissipation de chaleur ; et la plaque porteuse sur le deuxième côté étant reliée au circuit imprimé primaire de manière circonférentielle autour du volume d'accueil et l'évidement formant un espace creux (42) fermé et étanchéifié par le circuit imprimé primaire par rapport à l'environnement adjacent au module de commande de boîte de vitesses,
**caractérisé en ce que**
les plusieurs contacts sont au moins partiellement réalisés sous la forme de broches de contact à froid (46), et
les broches de contact à froid sont respectivement insérées dans une ouverture de passage (48) dans le circuit imprimé secondaire (30) et font saillie à travers celle-ci dans un logement (50) du circuit imprimé primaire (26), les ouvertures de passage (48) étant fermées par un élément de recouvrement (52) du côté de dissipation de chaleur (34).

2. Module de commande de boîte de vitesses selon la revendication 1, la plaque porteuse
i) étant une plaque massive (54) dans laquelle le volume d'accueil est réalisé sous la forme d'un évidement (56) ; ou
ii) étant une plaque profilée (58) dans laquelle le volume d'accueil est réalisé sous la forme d'un creux (60).

3. Module de commande de boîte de vitesses selon l'une des revendications précédentes, le circuit imprimé primaire possédant un orifice d'aération (64) continu avec lequel le volume d'accueil peut être relié temporairement à l'environnement limitrophe ; l'orifice d'aération étant fermé dans un état monté.

4. Module de commande de boîte de vitesses selon l'une des revendications précédentes, des éléments d'espacement (68) étant présents entre le circuit imprimé primaire et le circuit imprimé secondaire.

5. Module de commande de boîte de vitesses selon l'une des revendications précédentes, le circuit imprimé primaire possédant sur le côté qui fait face au circuit imprimé secondaire au moins une cavité (86) dans laquelle font saillie les composants du circuit imprimé secondaire qui se trouvent sur le côté de montage.

6. Module de commande de boîte de vitesses selon l'une des revendications précédentes, des pistes conductrices de dissociation (98) se trouvant sur le circuit imprimé primaire dans la zone de chevauchement avec le circuit imprimé secondaire pour dissocier le circuit sur le circuit imprimé secondaire.

7. Boîte de vitesses (100) pour un véhicule automobile, comprenant un dispositif de boîte de vitesses (110), un carter de boîte de vitesses (112) et un module de commande de boîte de vitesses (114, 10) selon l'une des revendications précédentes ; le dispositif de boîte de vitesses étant entouré par le carter de boîte de vitesses ; et le module de commande de boîte de vitesses étant fixé avec la plaque porteuse sur un côté intérieur (116) du carter de boîte de vitesses.
